# EUROPEAN PATENT APPLICATION

(11) **EP 2 363 439 A1**
(43) Date of publication of application: **07.09.2011**
(21) Application number: 11156580.0
(22) Date of filing: 02.03.2011
(51) Int. Cl.: C09J 7/02, C09J 133/06, C08K 5/32, C08K 5/57

(54) **Protective sheet and use thereof**

(30) Priority: 03.03.2010 JP 2010046992
(71) Applicant: NITTO DENKO CORPORATION, Ibaraki-shi, Osaka 567-8680 (JP)
(72) Inventor: Hayata, Maiko, Ibaraki-shi Osaka 567-8680 (JP); Inoue, Tsuyoshi, Ibaraki-shi Osaka 567-8680 (JP); Yamamoto, Mitsushi, Ibaraki-shi Osaka 567-8680 (JP)
(74) Representative: Grünecker, Kinkeldey, Stockmair & Schwanhäusser Anwaltssozietät

(57) **Abstract**

A protective sheet is provided that achieves both a high level of performance as a protective sheet (particularly a protective sheet for masking during plating) and an excellent ease of use. The protective sheet includes a substrate and a pressure-sensitive adhesive (PSA) layer which is provided on one side of the substrate. The PSA layer is formed of an acrylic PSA composition which includes a crosslinking agent and a crosslinking accelerator. The sum D_{S80} of a flexural rigidity D_{M80} of the protective sheet at 80°C in the machine direction and a flexural rigidity D_{T80} of the protective sheet at 80°C in the transverse direction is from 0.1x10⁻⁶ Pa.m³ to 1.2x10⁻⁶ Pa·m³. The PSA layer has a storage modulus G' at 100°C, as measured at a frequency of 1 Hz, of from 0.230x10⁻⁶ Pa to 10x10⁶ Pa.

## Description

### CROSS-REFERENCE

This application claims priority to Japanese Patent Application No. 2010-046992 filed on March 3, 2010, the entire contents of which are incorporated herein by reference.

### BACKGROUND OF THE INVENTION

### 1. Field of the Invention

The present invention relates to a protective sheet, and relates more particularly to a protective masking sheet that protects non-plating areas from the plating solution during metal plating.

### 2. Description of the Related Art

One process that is used for partially plating connection terminals and the like on circuit boards (e.g., printed circuit boards, flexible printed circuit boards (FPC)) involves attaching a pressure-sensitive adhesive (PSA) sheet to areas which are not to be plated (non-plating areas), and carrying out plating treatment in a state where such areas are protected from the plating solution. PSA sheets (protective sheets for masking during plating) used in this manner are typically constructed of a substrate which is a plastic film impermeable to the plating solution, and a PSA layer which is provided on one side of the substrate. An example of the technical literature relating to such protective sheets is Japanese Patent Application Publication No. 2004-115591. Moreover, other technical literature relating to PSA sheets includes Japanese Patent Application Publication Nos. 2007-138057 (about an optical film PSA sheet), 2004-137436 (about a double-sided adhesive tape) and 2005-203749 (about a tape for wafer processing).

A fine, complex topography owing to already formed circuits may be present on the surface of a circuit board like that described above. To prevent infiltration of the plating solution from the outer edges of the sheet to the non-plating areas, the protective sheet for covering the non-plating areas of such circuit board surfaces (protective sheets for masking during plating) is required to have the quality of conforming to the surface shape of the non-plating areas and closely adhering thereto without lifting or peeling ("surface conformability," or "adherence"). However, in cases where a thin substrate or a substrate having a high flexibility, for example, is used in order to increase adherence, because the protective sheet has a low stiffness (hardness) and release becomes difficult when the protective sheet is peeled from the adherend or the sheet itself has a tendency to tear or break apart, the ease of operation during peeling tends to decline. Such a decrease in handleability may become a major factor in lowering the manufacturability of products on which such a protective sheet is used (e.g., circuit boards the manufacture of which includes an operation wherein such a protective sheet is used for masking during plating).

### SUMMARY OF THE INVENTION

It is therefore an object of the invention to provide a protective sheet which achieves both a high level of performance (e.g., adherence) as a protective sheet (particularly a protective sheet for masking during plating) and an excellent ease of use (e.g., ease of operation during peeling from an adherend).

Accordingly, the invention provides a protective sheet having a substrate and a pressure-sensitive adhesive (PSA) layer provided on one side of the substrate. The PSA layer is formed of an acrylic PSA composition which includes a crosslinking agent and a crosslinking accelerator. The protective sheet is characterized by satisfying the following property: (A) for the protective sheet, when D_{M80} represents a flexural rigidity at 80°C in a machine direction thereof (referred to below as "MD"; typically the MD of the substrate) and D_{T80} represents a flexural rigidity at 80°C in a direction perpendicular to the machine direction (referred to below as the transverse direction, or "TD"; typically the TD of the substrate), the sum D_{S80} of D_{M80} and D_{T80} is from 0_{.}1X10⁻⁶ Pa·m³ to 1_{.}2x10⁻⁶ Pa·m³. Here, the flexural rigidity D (Pa·m³) at a predetermined temperature of the protective sheet in a predetermined direction is defined as the value determined by the formula D = Eh³/12(1-V²), where E is the tensile modulus of the protective sheet in the predetermined direction, h is the thickness of the substrate thereof and V is Poisson's ratio for the substrate. The protective sheet is also characterized by satisfying the following property: (B) the PSA layer has a storage modulus G' at 100°C, as measured at a frequency of 1 Hz, in a range of from 0.230x10⁶ Pa to 10X10⁶ Pa.

Because D_{S80} is at least 0.1x10⁻⁶ Pa·m³, this protective sheet has a suitable hardness (stiffness). Therefore, when it is placed at predetermined positions on an adherend (e.g., the non-plating areas of a circuit board), this protective sheet is easy to work with because it does not readily twist or wrinkle. Also, when the protective sheet is peeled from the adherend, it is easy to work with because the elastic forces of the protective sheet itself (the forces that work to restore the original shape against bending deformation) can be utilized as part of the peeling force. In addition, because D_{S80} is not more than 1.2x10⁻⁶ Pa·m³, by pressure-bonding the protective sheet to the adherend at a high temperature (e.g., from about 60°C to about 120°C, and typically from 90°C to 120°C), the protective sheet can be made to conform to the surface shape of the adherend and thus adhere closely thereto. Moreover, because the PSA layer of the protective sheet is formed of an acrylic PSA composition containing a crosslinking agent and a crosslinking accelerator, the PSA layer has a 100°C storage modulus G' in a range of from 0.230x10⁶ Pa to 10x10⁶ Pa, as a result of which, even when it is bonded to an adherend by heat and pressure bonding, release from the adherend does not become too difficult. This too is advantageous in terms of the ease of operation during peeling.

The substrate is preferably a polypropylene film, the crosslinking agent is preferably an isocyanate crosslinking agent, and the crosslinking accelerator is preferably a tin (Sn)-containing compound.

In one aspect of the protective sheet disclosed herein, it is preferable for the PSA layer to have a glass transition temperature (Tg) of at least -35°C (typically from -35°C to -10°C, such as from -30°C to -10°C). With a PSA layer that has a somewhat higher Tg than conventional pressure-sensitive adhesives and is relatively hard, even in cases where the protective sheet is formed using a soft substrate in order to improve adherence, a sufficient strength is achieved in the protective sheet, which is desirable because the protective sheet does not readily tear or break apart during peeling. With a PSA layer having such a Tg, a 100°C storage modulus G' in the above range is readily achieved.
A value measured as described below using a commercial viscoelastic analyzer (such as an ARES rheometer available from TA Instruments) may be employed as the Tg (°C) of the PSA layer. That is, a 2 mm thick measurement sample is formed in the same way as for the subsequently described storage modulus measurements, a 7.9 mm diameter disc is punched from the sample, the disc is immobilized on a 7.9 mm diameter parallel plate fixture, the temperature dependence of the loss modulus G" is measured under the following measurement conditions with the above viscoelastic analyzer, and the temperature at which the resulting G" curve reaches a maximum is treated as the Tg (°C). The measurement conditions are as follows.
Measurement: shear mode
Temperature range: -70°C to 150°C
Temperature rise rate: 5°C/min
Frequency: 1 Hz

In one aspect, it is preferable for the PSA composition to include an acrylic polymer obtained by emulsion polymerization as the base polymer (the primary adhesive component). With such a PSA composition, a PSA layer having a 100°C storage modulus G' in the above range can be efficiently achieved.

In another aspect, the above protective sheet is characterized by further satisfying the following property: (C) when the protective sheet is press bonded to an evaluation adherend at 120°C and a pressure of 0.34 MPa for a pressing time of 5 seconds, and then held at 50°C for 24 hours, the protective sheet has a peel strength PS_{HP}, as measured by peeling the protective sheet from the adherend at 25°C, a peel rate of 300 mm/min and a peel angle of 180°, of from 0.1 N/10 mm to 1.0 N/10 mm. Such a protective sheet exhibits a good adhesion when heat and pressure bonded to the adherend, in addition to which it does not damage the surface shape of the adherend during release and can be peeled from the adherend without inviting a decline in operational efficiency due to problems such as tearing and breaking apart of the protective sheet itself.

In another preferred aspect, the above protective sheet further satisfies the following property: (D) when E_{M25} represents a tensile modulus at 25°C in the MD and E_{T25} represents a tensile modulus at 25°C in the TD, the sum E_{S25} of E_{M25} and E_{T25} is from 50 MPa to 9000 MPa. Such a protective sheet is capable of exhibiting a better adherence to the adherend and a better ease of use during attachment and peeling.

In yet another preferred aspect, the above protective sheet further satisfies the following property: (E) when T_{M25} represents a tension when stretched 10% in the MD at 25°C and T_{T25} represents a tension when stretched 10% in the TD at 25°C, the sum T_{S25} of T_{M25} and T_{T25} is from 8 N/10 mm to 60 N/10 mm. Such a protective sheet does not readily give rise to excessive stretch during handling and is capable of exhibiting an even better dimensional stability.

Any of the protective sheets disclosed herein is suitable as a protective sheet for masking during plating which is attached to non-plating areas during metal plating so as to protect such areas from the plating solution. These protective masking sheets may be used, for example, in a process for partially plating connection terminals on a circuit board.

### BRIEF DESCRIPTION OF THE DRAWINGS

FIG. 1 is a schematic cross-sectional diagram of an embodiment of the protective sheet according to the present invention;
FIG. 2 is a schematic cross-sectional diagram of another embodiment of the protective sheet of the present invention;
FIG. 3 is a front view illustrating a method for evaluating adherence;
FIG. 4 is a cross-sectional view taken along line IV-IV in FIG. 3; and
FIG. 5 is a schematic perspective view of a test piece used in a test to evaluate durability during peeling.

### DETAILED DESCRIPTION OF THE INVENTION

Preferred embodiments of the present invention are described below. Technical matters necessary to practice the invention, other than those specifically referred to in the present description, may be understood as design matters for a person skilled in the art that are based on the related art in the pertinent field. The present invention may be practiced based on the contents disclosed herein and common general technical knowledge in the pertinent field.

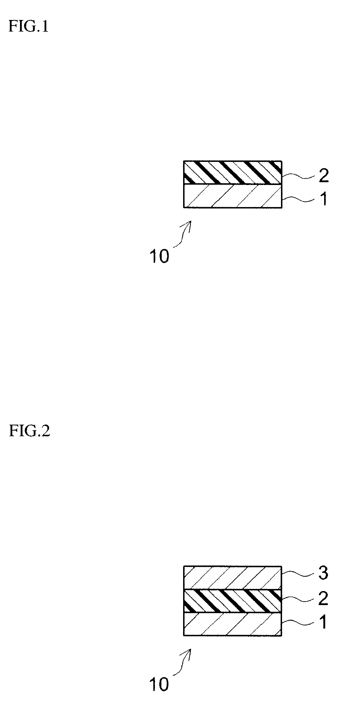

A protective sheet disclosed herein has a substrate, and a PSA layer which is provided on one side of the substrate. FIG. 1 schematically shows a typical construction of the protective sheet provided by the present invention. This protective sheet 10, which has a sheet-shaped substrate 1 made of plastic and a PSA layer 2 provided on a first side (one side) thereof, is used by attaching the PSA layer 2 to given places (areas to be protected, e.g., in the case of protective sheets for masking during plating, non-plating areas) on an adherend. The protective sheet 10 prior to use (that is, prior to attachment to the adherend) may typically be in a form where, as shown in FIG. 2, the surface (attaching side) of the PSA layer 2 is protected by a release liner 3 having a release face (release side) on at least the PSA layer 2 side thereof. Alternatively, the protective sheet 10 may have a construction wherein the second side of the substrate 1 (the back side from the side where the PSA layer 2 is provided) is a release side and, by coiling the protective sheet 10 into a roll, the second side comes into direct contact with the PSA layer 2 in such a way as to protect the surface thereof.

In the present specification, the total flexural rigidity D_{S80} at 80°C of the protective sheet is defined as the sum of the flexural rigidity D_{M80} of the protective sheet at 80°C in a first direction (typically, the machine direction, or "MD") and the flexural rigidity D_{T80} of the protective sheet at the same temperature in a second direction (typically, the transverse direction, or "TD"). D_{M80} is a value determined by the formula D_{M80} = E_{M80}h³/12(1-V²), where h is the thickness of the substrate, V is Poisson's ratio for the substrate, and E_{M80} is the tensile modulus of the protective sheet at 80°C in the first direction (MD). D_{T80} is a value similarly determined by the formula D_{T80} = E_{TS80}h³/12(1-V²)where E_{T80} is the tensile modulus of the protective sheet at 80°C in the second direction (TD).

The MD tensile modulus E_{M80} of the protective sheet can be calculated from the linear regression of the stress-strain curve obtained by cutting out a test piece at a predetermined width from the protective sheet along the machine direction thereof and, in accordance with JIS K7161, stretching the test piece in the machine direction at a measurement temperature of 80°C and a pulling rate of 300 mm/min. The TD tensile modulus E_{T80} can be similarly calculated using a test piece cut out at a predetermined width from the protective sheet along the transverse direction thereof. More specifically, the values measured at predetermined temperatures in accordance with the tensile modulus measurement method described in the subsequent examples can be employed. Poisson's ratio V is a value (non-dimensional number) determined by the substrate material. When this material is a resin, a value of 0.35 can generally be used as V. Because the tensile modulus of the PSA layer is very small compared with the tensile modulus of the substrate, the tensile modulus of the protective sheet may be substantially the same as the tensile modulus of the substrate. Therefore, in this specification, the tensile modulus E of the protective sheet shall be understood to refer to a value determined with respect to the cross-sectional area of the substrate making up the protective sheet. The cross-sectional area of the substrate is calculated based on the thickness of the substrate. The thickness of the substrate is the value obtained by subtracting the thickness of the PSA layer from the measured thickness of the protective sheet.

The total flexural rigidity D_{S80} at 80°C of the protective sheet disclosed herein is 1.2x10⁻⁶ Pa·m³ or less (typically, from 0.1x10⁻⁶ to 1.2x10⁻⁶ Pa·M³). If D_{S80} is too large, even when the protective sheet is pressure-bonded to an adherend at a high temperature (e.g., about 60°C to 120°C), the protective sheet will tend to not fully follow the surface shape of the adherend. As a result, the adherence of the protective sheet tends to be inadequate. In an aspect of the protective sheet disclosed herein, the D_{S80} of the protective sheet is at least 0.10xl0⁻⁶ Pa·m³ (typically, at least 0.25x10⁻⁶ Pa·m³, and generally at least 0.50x10⁻⁶ Pa·m³).

In a preferred embodiment of the protective sheet disclosed herein, the sum E_{S25} of, for the protective sheet at 25°C, the tensile modulus E_{M25} in the machine direction and the tensile modulus E_{T25} in the transverse direction is preferably at least 50 MPa, more preferably at least 800 MPa, and even more preferably at least 1,000 MPa (e.g., 1,100 MPa or more). Such a protective sheet has an excellent handleability in room-temperature environments. In a preferred embodiment, the E_{S25} of the protective sheet is not more than 9,000 MPa. For example, the value may be 8,000 MPa or less, and is typically 4,000 MPa or less (e.g., 2,000 MPa or less). Such a protective sheet tends to have a suitable D_{S80} value, and thus tends to have an excellent adherence. If E_{S25} is too small, the handleability may decrease. On the other hand, if E_{S25} is too large, a sufficient adherence may not be attainable.

Various types of plastic films (typically, a film composed primarily of a thermoplastic resin) may be employed as the substrate described above. For example, in cases where the protective sheet according to the present invention is a protective sheet for masking during plating, a film composed of a resin material having resistance to the plating solution likely to be used is preferred. Preferred examples of the resin component used in the substrate include polyolefin resins such as polyethylene and polypropylene, polyamide resins (PA), polycarbonate resins (PC), polyurethane resins (PU), ethylene-vinyl acetate resins (EVA) and acrylic resins. The substrate may be composed of a resin material containing one such type of resin used alone, or may be composed or a resin material blended from two or more resins. The substrate may have a single-layer structure or a multilayer structure of two or more layers (e.g., a three-layer structure). In a plastic film having a multilayer structure, the resin material making up each of the respective layers may be, as described above, a resin material containing a single type of resin by itself, or may be a resin material blended from two or more resins.

In a preferred embodiment, the substrate is a single-layer or multilayer polyolefin resin film. Here, "polyolefin resin film" refers to a film in which a polyolefin resin (i.e., a resin composed primarily of polyolefin) is used as a primary component among the resin components making up the film. The film may be one in which the resin components are substantially composed of polyolefin resins. Alternatively, the film may be formed of a resin material containing a polyolefin resin as the primary component (e.g., a resin component accounting for at least 50 wt%), and additionally containing a resin component other than a polyolefin resin (e.g., PA, PC, PU, EVA). The polyolefin used may be a single type of polyolefin alone, or a combination of two or more polyolefins. The polyolefin may be, for example, a homopolymer of an α-olefin, a copolymer of two or more α-olefins, or a copolymer of one, two or more α-olefins with another vinyl monomer. Specific examples include polyethylene (PE), polypropylene (PP), ethylene-propylene copolymers, ethylene-propylene-butene copolymers, ethylene-propylene rubber (EPR) and ethylene-ethyl acrylate copolymers. Both low-density (LD) polyolefins and high-density (HD) polyolefins may be used.

Ingredients suitable for the intended use of the protective sheet may be optionally included in the substrate. For example, additives such as light stabilizers (e.g., radical scavengers, ultraviolet absorbers), antioxidants, antistatic agents, colorants (e.g., dyes, pigments), fillers, slip agents and anti-blocking agents may be suitably included. Examples of light stabilizers include those containing any of the following as the active ingredient: benzotriazoles, hindered amines, and benzoates. Examples of antioxidants include those containing any of the following as the active ingredient: alkylphenols, alkylene bisphenols, thiopropylene acid esters, organic phosphites, amines, hydroquinones and hydroxylamines. Each of these types of additives may be used singly or as a combination of two or more thereof. The loadings of these additives may, depending on the intended use of the protective sheet (e.g., for masking in a plating operation), be made about the same as conventional loadings for plastic films used as the substrate in such applications.

Such a substrate (plastic film) may be manufactured by suitably employing an ordinary known film-forming process (e.g., extrusion, inflation). The surface of the substrate on the side where the PSA layer is provided (PSA layer side surface) may be subjected to treatment for enhancing adhesion with the PSA layer, such as corona discharge treatment, acid treatment, ultraviolet irradiation treatment, plasma treatment, or primer coating. The face of the substrate on the side opposite from the PSA layer side surface (referred to herein as the "back side") may be optionally subjected to surface treatment such as antistatic treatment or release treatment.

The thickness of the substrate may be suitably selected according to the intended use of the protective sheet and the degree of stiffness (hardness) and other properties of the resin film to be employed. For example, a substrate having a thickness of from about 10 µm to about 80 µm may be used. Generally, the use of a substrate having a thickness of from about 20 µm to about 70 µm (typically, from 20 µm to 50 µm, such as 25 µm or more but less than 40 µm) is suitable. If the substrate thickness is too much larger than the above range, the adherence may decrease. On the other hand, if the substrate thickness is too much smaller than the above range, the handleability at the time of attachment and peeling may diminish.

As described above, at a predetermined temperature, the tensile modulus E of the protective sheet in a predetermined direction may be substantially the same as the tensile modulus E of the substrate in the predetermined direction. Therefore, if the sum of the MD tensile modulus and the TD tensile modulus of the substrate at 25°C is E_{SubS25}, by selecting a substrate such that E_{SubS25} is substantially the same as the above-indicated preferred range of E_{S25} for the protective sheet, a protective sheet having a E_{S25} value in the above preferred range can be advantageously formed.

Likewise, with regard also to the flexural rigidity D which is calculated based on the tensile modulus, the flexural rigidity D of the protective sheet in a predetermined direction may be substantially the same as the flexural rigidity D of the substrate in the predetermined direction. Therefore, if the sum of the MD flexural rigidity and the TD flexural rigidity of the substrate at 80°C is D_{Subs80}, by selecting a substrate such that D_{SubS80} is substantially the same as the above-indicated preferred range of D_{S80} for the protective sheet, a protective sheet having a D_{S80} value in the above preferred range can be advantageously formed.

The PSA layer provided on the substrate is characterized by having a storage modulus G' at 100°C in a range of from 0.230x10⁶ Pa to 10x10⁶ Pa. G' is preferably in a range of from 0.230x10⁶ Pa to 1.0X10⁶ Pa (e.g., from 0.3x10⁶ Pa to 0.5x10⁶ Pa). The storage modulus G' measurement frequency is set at 1 Hz. This storage modulus can be determined by, for example, setting a 2 mm thick PSA layer sample between the parallel plate (7.9 mm diameter) of an ordinary viscoelastic analyzer and a flat plate, and carrying out measurement at the above frequency in the shear mode. The measurement temperature range and the temperature ramp-up rate may be set as appropriate for, e.g., the model of the viscoelastic analyzer. For example, a temperature range that includes a range of at least 50°C to 130°C (e.g., 15°C to 150°C) as the measurement temperature may be used, and the ramp-up rate may be set to from about 0.5°C/min to about 15°C/min (e.g., 5°C/min).

The acrylic PSA composition used to form the PSA layer includes, as a base polymer (that is, the primary component from among the polymer components, or the primary adhesive component), an acrylic polymer. The acrylic polymer is typically a copolymer of a monomer mixture which includes alkyl (meth)acrylate as the primary monomer and additionally includes a secondary monomer that is copolymerizable with the primary monomer. The monomer mixture may optionally include other monomers in addition to these primary and secondary monomers. In the present specification, "(meth)acrylate" refers collectively to acrylate and methacrylate. Likewise, "(meth)acryloyl" refers collectively to acryloyl and methacryloyl, and "(meth)acryl" refers collectively to acryl and methacryl.

Compounds of the following formula (1) may be preferably used as the above alkyl (meth)acrylate.

CH₂=C(R¹)COOR² (1)

In formula (1), R¹ is a hydrogen atom or a methyl group. R² is an alkyl group of from 1 to 20 carbon atoms (such a range in the number of carbon atoms is denoted below as "C₁₋ 20"). From the standpoint of the storage modulus and other properties of the PSA, R² is preferably an alkyl (meth)acrylate having a C₁₋₁₄ alkyl group, and more preferably an alkyl (meth)acrylate having a C₁₋₁₀ alkyl group.

Illustrative examples of the above alkyl (meth)acrylate having a C₁₋₂₀ group include methyl (meth)acrylate, ethyl (meth)acrylate, propyl (meth)acrylate, isopropyl (meth)acrylate, n-butyl (meth)acrylate, isobutyl (meth)acrylate, s-butyl (meth)acrylate, pentyl (meth)acrylate, isopentyl (meth)acrylate, hexyl (meth)acrylate, heptyl (meth)acrylate, 2-ethylhexyl (meth)acrylate, octyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate and eicosyl (meth)acrylate. These alkyl (meth)acrylates may be used singly or as combinations of two or more thereof. More preferred alkyl (meth)acrylates include n-butyl acrylate, methyl methacrylate and 2-ethylhexyl acrylate. Acrylic polymers copolymerized with one, two or more of these in a combined ratio of at least 50 wt% are preferred.

A monomer which is copolymerizable with the alkyl (meth)acrylate and has at least one functional group capable of introducing a crosslinking site to the PSA (PSA layer) that is to be formed from the PSA composition may be used as the secondary monomer. An ethylenically unsaturated monomer having a pendant functional group, such as a hydroxyl group, silanol group, carboxyl group, thiol group, amino group, mercapto group or chlorosulfone group is typically used. Of these, the use of a hydroxyl group-bearing monomer is preferred.

Preferred examples of hydroxyl group-bearing monomers include hydroxyalkyl (meth)acrylates such as 2-hydroxyethyl (meth)acrylate, 2-hydroxypropyl (meth)acrylate, 3-hydroxypropyl (meth)acrylate, 2-hydroxybutyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate and [4-(hydroxymethyl)cyclohexyl]methyl acrylate. An especially preferred example is 2-hydroxyethyl methacrylate.

The amount of secondary monomer included in the monomer mixture may be suitably selected according to the desired degree of crosslinking. For example, this amount may be set to from about 1 part by weight to about 10 parts by weight per 100 parts by weight of the total monomer components.

Various ethylenically unsaturated monomers which are copolymerizable with at least one (and typically both) of the above primary monomer and the above secondary monomer may be used as optional monomers that may be included in the above monomer mixture.

The method of polymerizing the monomer mixture is not subject to any particular limitation; use may be made of an ordinary known polymerization method (e.g., emulsion polymerization, solution polymerization). For example, preferred use may be made of emulsion polymerization. No particular limitation is imposed on the manner in which emulsion polymerization is carried out. For example, various known monomer feeding methods, polymerization conditions (e.g., polymerization temperature, polymerization time, polymerization pressure) and materials (polymerization initiators, surfactants, etc.) may be suitably employed in a manner similar to ordinary emulsion polymerization as hitherto known and practiced. By way of illustration, the monomer feeding method may be a method which feeds all the monomer mixture into the polymerization vessel at once, a method that adds the monomer mixture continuously in a dropwise manner, and a method that feeds (in a dropwise manner) the monomer mixture in divided amounts. It is also possible to first emulsify some or all of the monomer mixture in the presence of a suitable surfactant, then feed the resulting liquid emulsion to the reaction vessel.

Exemplary polymerization initiators include, but are not limited to, azo initiators, peroxide initiators, substituted ethane initiators, and redox initiators obtained by combining a peroxide and a reducing agent.
Illustrative examples of azo initiators include 2,2'-azobis(2-amidinopropane) dihydrochloride, 2,2'-azobis[N-(2-carboxyethyl)-2-methylpropionamidine] hydrate, 2,2'-azobisisobutyronitrile, 2,2'-azobis(2-methylpropionamidine) disulfate, 2,2'-azobis[2-(5-methyl-2-imidazolin-2-yl)propane] dihydrochloride and 2,2'-azobis(N,N'-dimethyleneisobutylamidine) dihydrochloride.
Illustrative examples of peroxide initiators include persulfates such as potassium persulfate and ammonium persulfate, benzoyl peroxide, t-butylhydroperoxide and hydrogen peroxide.
An example of a substituted ethane initiator is phenyl-substituted ethane.
Illustrative examples of redox initiators include a persulfate in combination with sodium bisulfite, and a peroxide in combination with sodium ascorbate.

The amount of polymerization initiator used may be suitably selected according to, for example, the type of initiator and the types of monomers (the composition of the monomer mixture). Generally, it is suitable to select the amount of use from a range of, for example, from about 0.005 to about 1 part by weight per 100 parts by weight of the total monomer components.
The polymerization initiator feeding method employed may be any of the following, for example: a batching feeding method which charges substantially all of the polymerization initiator to be used in the reaction vessel before feeding of the monomer mixture begins (typically, an aqueous solution of the polymerization initiator is provided within the reaction vessel), a continuous feeding method, or a divided feeding method. From the standpoint of the ease of polymerization operation and the ease of process control, preferred use may be made of, for example, a batch feeding process.
The polymerization temperature may be set to, for example, from about 20°C to about 100°C (typically, from 40°C to 80°C).

Exemplary emulsifying agents (surfactants) that may be used include anionic emulsifying agents and nonionic emulsifying agents. Illustrative examples of anionic emulsifying agents include sodium dodecylbenzene sulfonate, sodium polyoxyethylene alkyl ether sulfate, ammonium polyoxyethylene alkyl phenyl ether sulfate, sodium polyoxyethylene alkyl phenyl ether sulfate, sodium lauryl sulfate, ammonium lauryl sulfate and sodium polyoxyethylene alkyl sulfosuccinate. Illustrative examples of nonionic emulsifying agents include polyoxyethylene alkyl ethers, polyoxyethylene alkyl phenyl ethers, polyoxyethylene fatty acid esters and polyoxyethylene polyoxypropylene block polymers. Use may also be made of a radical polymerizable emulsifying agent (reactive emulsifying agent) having a structure wherein a radical polymerizable group (e.g., vinyl, propenyl, isopropenyl, vinyl ether (vinyloxy), allyl ether (allyloxy)) has been introduced onto the above anionic or nonionic emulsifying agent. Such emulsifying agents may be used singly or as combinations of two or more thereof. The amount of emulsifying agent used (solids basis) may be set to, for example, from about 0.2 to 10 parts by weight (preferably from about 0.5 to about 5 parts by weight) per 100 parts by weight of the total monomer components.

Various known chain transfer agents (which may also be thought of as molecular weight regulators or degree of polymerization regulators) may be optionally used in the above polymerization. Such a chain transfer agent may be of one, two or more types selected from among, for example, mercaptans such as dodecylmercaptan (dodecanethiol), glycidylmercaptan, 2-mercaptoethanol, mercaptoacetic acid, 2-ethylhexyl thioglycolate and 2,3-dimercapto-1-propanol.

In addition to the above acrylic polymer serving as the base polymer, the acrylic PSA composition also includes a crosslinking agent. The type of crosslinking agent is not subject to any particular limitation, and may be suitably (e.g., according to the crosslinkable functional group on the secondary monomer) selected from among various types of crosslinking agents commonly used in the PSA field. Exemplary crosslinking agents include isocyanate crosslinking agents, silane crosslinking agents, epoxy crosslinking agents, oxazoline crosslinking agents, aziridine crosslinking agents and metal chelate crosslinking agents. For example, when a hydroxyl group-bearing monomer is used as the secondary monomer, preferred use may be made of an isocyanate crosslinking agent. The amount of crosslinking agent included in the PSA composition may be set to, for example, from about 2 to about 10 parts by weight (preferably from about 3 to about 7 parts by weight) per 100 parts by weight of the acrylic polymer.

The acrylic PSA composition further includes a crosslinking accelerator. The type of crosslinking accelerator may be suitably selected according to the type of crosslinking agent. In the present specification, "crosslinking accelerator" refers to a catalyst which increases the rate of the crosslinking reaction by the crosslinking agent. Illustrative examples of such crosslinking accelerators include tin (Sn)-containing compounds such as dioctyltin dilaurate, dibutyltin dilaurate, dibutyltin diacetate, dibutyltin diacetylacetonate, tetra-n-butyltin and trimethyltin hydroxide; and nitrogen-containing compounds, including amines such as N,N,N',N'-tetramethylhexanediamine and triethylamine, and imidazoles. Of these, tin-containing compounds are preferred. The use of these crosslinking accelerators is particularly effective in cases where a hydroxyl group-bearing monomer is used as the secondary monomer and an isocyanate crosslinking agent is used as the crosslinking agent. The amount of crosslinking accelerator included in the PSA composition may be set to, for example, from about 0.001 to 0.5 part by weight (preferably from about 0.001 to about 0.1 part by weight) per 100 parts by weight of the acrylic polymer.

The PSA composition may also include other ingredients, such as one which contains an acidic or basic group (e.g., ammonia water) for the purpose of adjusting the pH. Examples of other, optional, ingredients that may be included in the composition include various additives which are commonly used in the PSA field, such as antistatic agents, slip agents, antiblocking agents, viscosity modifiers, leveling agents, plasticizers, fillers, colorants (pigments, dyes, etc.), stabilizers, preservatives and antioxidants. The loadings of such additives may, depending on the intended use of the protective sheet (e.g., for masking in a plating operation), be made about the same as conventional loadings for PSA compositions used in the formation of the PSA layer (production of the protective sheet) in such applications.

The form of the PSA composition is not subject to any particular limitation. For example the PSA composition may be in a solvent form, an emulsion form, an aqueous solution form, an actinic energy (e.g., UV) curable form, or a hot-melt form. Typically, the acrylic polymer is prepared by dissolution or dispersion, together with the other ingredients (crosslinking agent, crosslinking accelerator, etc.), in a suitable solvent. For example, the PSA composition may be a solvent-based PSA composition which is prepared by dissolving the acrylic polymer obtained by emulsion polymerization (followed by treatment such as pH adjustment, salting out, and purification, where necessary), together with the crosslinking agent, the crosslinking accelerator and various other additives (optional ingredients), as needed, in an organic solvent such as toluene or ethyl acetate.

Examples of methods that may be used to provide a PSA layer on the substrate include a method in which the above PSA composition is directly applied (typically, coated) to the substrate and cured (direct method); and a method in which the PSA layer is formed by applying the above PSA composition to a surface having releasability (release surface) and curing, then laminating this PSA layer onto the substrate and transferring the PSA layer to the substrate (transfer method). The curing treatment may involve one, two or more treatment selected from among, for example, drying (heating), cooling, crosslinking, supplementary copolymerization reactions, and aging. For example, what is referred to herein as the curing treatment encompasses also treatments which consist solely of simply drying a solvent-containing PSA composition (e.g., heating treatment) and treatments which consist solely of simply cooling a PSA composition in a hot molten state (solidification). When curing treatment includes two or more treatments (e.g., drying and crosslinking), these treatments may be carried out at the same time or may be carried out in a plurality of stages.

Coating of the PSA composition may be carried out using a conventional coater, such as a gravure roll coater, reverse roll coater, kiss roll coater, dip roll coater, bar coater, knife coater and spray coater. From the standpoint of accelerating the crosslinking reaction and increasing production efficiency, it is preferable to carry out drying of the PSA composition under applied heat. Although dependent also on the type of backing to be coated by the composition, a drying temperature of, e.g., from about 40°C to about 150°C may be employed. In the case of a PSA sheet having an attached substrate, the PSA layer may be formed by directly applying the PSA composition to the substrate, or by laminating (transferring) to the substrate a PSA layer that has been pre-formed on a release liner. After drying, aging treatment which holds the PSA layer at about 40°C to 60°C may be carried out so that the crosslinking reaction proceeds further. The aging time may be suitably selected according to the desired degree of crosslinking and the rate at which the crosslinking reaction proceeds, and may be set to, for example, from about 12 hours to about 72 hours.

The thickness of the PSA layer may be, for example, from about 1 µm to about 100 µm. Generally, it is preferable to set the thickness of the PSA layer to from about 5 µm to about 40 µm (e.g., from about 10 µm to about 20 µm). For example, the above range may be advantageously used as the thickness of the PSA layer in a protective sheet for masking during plating.

In the present specification, the peel strength of the protective sheet when heat and pressure bonded (heat/pressure bonding adhesive strength) PS_{HP} is defined as the value obtained by press-bonding the protective sheet to an evaluation adherend at 120°C and a pressure of 0.34 MPa for a pressing time of 5 seconds, then holding the sheet at 50°C for 24 hours, and subsequently peeling the protective sheet from the adherend at 25°C, a peel rate of 300 mm/min and a peel angle of 180°. In a preferred embodiment, PS_{HP} is from about 0.1 N/10 mm to about 1.0 N/10 mm. If the PS_{HP} is too high, the easy releasability when heat and pressure bonded may decline. On the other hand, if the PS_{HP} is too low, sufficient adhesion may not be achieved even when heat and pressure bonded. For example, on the surface of an ordinary circuit board prior to plating, generally there is a large portion of areas where the polyimide (PI) board is exposed. Because a protective sheet with a PS_{HP} in the above range has an excellent balance between adhesion when it has been heat and pressure bonded to the polyimide and easy releasability, it is well-suited for use in protecting non-plating areas during the plating of a circuit board. The value measured as described below are employed as the above adhesive strength PS_{HP} when heat and pressure bonded.

### Measurement of Adhesive Strength PS_{HP} When Heat and Pressure Bonded

A PSA layer exposed by removing the release liner from a protective sheet cut to a size of 10 mm x 60 mm with the machine direction (sometimes abbreviated below as "MD"; typically the lengthwise direction of the substrate) of the substrate as the lengthwise direction is placed over an evaluation adherend cut to a size of 15 mm x 60 mm as the adherend and temporarily attached thereto solely under the weight of an 83 g hand roller by passing the roller once back and forth over the sheet. This is then sandwiched between two layers of a suitable rubber sheet and pressed from above the rubber sheet (on the protective sheet side) at a temperature of 120°C and a pressure of 0.34 MPa for a pressing time of 5 seconds, thereby heat and pressure bonding the protective sheet to the adherend. At this time, in order to keep the molten PSA of the protective sheet from sticking to the rubber sheet, it is desirable to place, both between the protective sheet and the rubber sheet and also between the adherend and the rubber sheet, a polyethylene terephthalate (PET) film or the like that has been release-treated with silicone or the like. The adherend to which the protective sheet has been heat and pressure bonded is held at 50°C for 24 hours, then attached to a stainless steel plate (SUS 430BA) using double-sided PSA tape. Next, the protective sheet is peeled from the adherend that has been attached to the steel plate at a temperature of 25°C, a peel rate of 300 mm/min and a peel angle of 180° in accordance with JIS Z0237, and the peel strength at that time is measured as the adhesive strength PS_{HP} (N/10 mm) when heat and pressure bonded.

The evaluation adherend, assuming a case in which a protective sheet is temporarily attached to the surface of a FPC where an adhesive layer that had fixed a copper foil to the FPC lies exposed after the copper foil has been etched out (PI board surface after etching out; surface having a relatively high adhesive strength compared with other areas of the board surface), is a PI board having a PSA surface similar to the FPC surface. The evaluation adherend used here is one obtained by providing a PSA layer having a thickness of 25 µm which includes 100 parts by weight of an alkyl acrylate-acrylonitrile-acrylic copolymer (available from Toray Coatex Co., Ltd. under the trade name "Rheocoat R-7000"), 30 parts by weight of a bisphenol A-based solid epoxy resin (available from Japan Epoxy Resin Co., Ltd. under the trade name "jER 1001") and 30 parts by weight of a phenolic resin (available from Sumitomo Bakelite Co., Ltd. under the trade name Sumilite Resin PR-51283") on one side of a PI film (available from DuPont-Toray Co., Ltd. under the trade name "Kapton 200H").

In a typical aspect of the protective sheet disclosed herein, the sum T_{S25} for the protective sheet at 25°C of the tension T_{M25} when stretched 10% in the machine direction and the tension T_{T25} when stretched 10% in the transverse direction perpendicular to the machine direction is at least 8 N/10 mm (typically, from 8 N/10 mm to 100 N/10 mm). T_{S25} may be 12 N/10 mm or more, and may even be 14 N/10 mm or more. With such a protective sheet, a better dimensional stability can be achieved. There is no particular upper limit for T_{S25}. For example, a protective sheet having a T_{S25} value of 100 N/10 mm or less (typically, 60 N/10 mm or less, and generally 30 N/10 mm or less) is possible. T_{M25} and T_{S25} refer to the tensile strengths when 10 mm wide test pieces that have been cut out along the respective directions of measurement are stretched 10% at a temperature of 25°C and a pulling rate of 300 mm/min, in accordance with JIS K7127. More specifically, use may be made of values obtained by the method of measuring the tension when stretched 10% that is described subsequently in the examples.

In a typical example of the protective sheet disclosed herein, the sum S_{S25} for the protective sheet at 25°C of the tear strength S_{M25} in the machine direction and the tear strength S_{T25} in the transverse direction perpendicular to the machine direction is at least 3.0 N. Because such a protective sheet has the desired resistance to tearing, a better handleability can be achieved. For example, when the protective sheet is peeled from an adherend, because the protective sheet does not readily tear, a better ease of operation in peeling can be achieved. S_{S25} is preferably at least 5.0 N, and more preferably at least 6.0 N (e.g., 7.0 N or more). There is no particular upper limit for S_{S25}. In one aspect of the protective sheet disclosed herein, S_{S25} is 20 N or less (e.g., 15 N or less). S_{M25} and S_{T25} are determined, in accordance with JIS K6772, as the maximum load when a test piece is torn at a temperature of 25°C in the measurement direction. More specifically, use may be made of values obtained by the method of measuring tear strength that is described subsequently in the examples.

In a typical example of the protective sheet disclosed herein, the sum H_{S25} for the protective sheet at 25°C of the breaking strength H_{M25} in the machine direction and the breaking strength H_{T25} in the transverse direction perpendicular to the machine direction is at least 18 N/10 mm. Because such a protective sheet has the desired resistance to breaking apart, a better handleability can be achieved. For example, when a protective sheet is peeled from an adherend, because the protective sheet does not readily break apart, a better ease of operation in peeling can be achieved. H_{S25} is more preferably at least 20 N/10 mm, and even more preferably at least 30 N/10 mm. There is no particular upper limit for H_{S25}. In one embodiment of the protective sheet disclosed herein, H_{S25} is 140 N/10 mm or less, and typically 100 N/10 mm or less (e.g., 50 N/10 mm or less). H_{M25} and H_{T25} are determined, in accordance with JIS K7161, as the maximum loads when a test piece is pulled, at a measurement temperature of 25°C, in the respective measurement directions until it breaks apart. More specifically, use may be made of values obtained by the method of measuring breaking strength that is described subsequently in the examples.

The protective sheet disclosed herein may be in a form wherein a release liner is disposed on the PSA layer surface (the PSA side, i.e., the surface on the side of the protective sheet which will be attached to the object to be protected). A protective sheet in such a form (a protective sheet with release liner) may be advantageously employed as a protective sheet for masking during a plating operation. This is because, generally, when the protective sheet for masking during plating is punched in a shape that corresponds to the masking region (that is, the region to be protected) and is attached to an adherend, a protective sheet in a form having a release liner on a PSA layer (that is, a protective sheet with release liner) enables the punching operation to be efficiently carried out. After the protective sheet with release liner has been punched, it is used by peeling the release liner from the protective sheet so as to expose the PSA side, then pressure-bonding the PSA side to the adherend.

Various types of paper (which may be paper to the surface of which a resin has been laminated), plastic films and the like may be used without particular limitation as the release liner. In cases where a plastic film is used as the release liner, preferred examples of the resin component making up the plastic film include polyolefin resins, polyester resins (e.g., PET), PA, PC and PU. The plastic film may be one composed of a resin material which includes one such type of resin alone, or may be a plastic film composed of a resin material blended from two or more resins (e.g., polyethylene and polypropylene). The plastic film may have a single-layer structure or a multilayer structure of two or more layers. As with the plastic film serving as the substrate, such plastic films for the release liner may be produced by suitably employing a common film-forming method.

The thickness of the release liner is not subject to any particular limitation and may be, for example, from about 5 µm to about 500 µm (and preferably from about 10 µm to about 200 µm, such as from about 30 µm to about 200 µm). The release side of the release liner (the side situated in contact with the PSA side) may optionally be subjected to release treatment with a known release agent (e.g., a common silicone, long-chain alkyl or fluorocarbon release agent). The back side of the release surface may or may not be release-treated, and may be subjected to a surface treatment other than release treatment.

The protective sheet disclosed herein is suitable as a protective sheet for masking in a plating operation. For example, when a metal (typically a metal having a high electrical conductivity, such as gold or nickel) is plated (e.g., electroplated) onto portions of a workpiece, the protective sheet may be advantageously used in applications where it is attached to non-plating areas and protects those non-plating areas from the plating solution. Such a protective sheet for masking during plating may be advantageously used in operations wherein portions (e.g., connection terminal areas) of a circuit board (e.g., a printed circuit board or FPC) are partially plated. Because the protective sheet according to this invention has a good adherence, infiltration of the plating solution into non-plating areas is suppressed, enabling plating to be precisely applied. For example, in the adherence test described in the subsequent examples, the protective sheet can exhibit high adherence that does not allow the presence of an observable gap enabling the infiltration of plating solution. The protective sheet disclosed herein has an excellent handleability. For example, the ease of operation is good when the protective sheet is attached to non-plating areas, or when the protective sheet is peeled following plating. Therefore, by using the protective sheet according to the present invention to carry out masking in a plating operation, high-quality circuit boards can be manufactured efficiently.
The protective sheet according to this invention is not limited to applications in which, as described above, areas which are not to be metal plated are protected from the plating solution, and may also be advantageously used in such applications as, for example, protecting (masking) a non-patterned side from the processing solution in a circuit patterning operation.

### EXAMPLES

Several experimental examples of the invention are described below, although these specific examples are not intended to limit the scope of the invention. In the description that follows, unless noted otherwise, all references to "parts" and "%" are based on weight.

### Production of Protective Sheet

### Example 1

A reaction vessel equipped with a condenser, nitrogen inlet, thermometer and stirrer was charged with 64 parts of butyl acrylate, 33 parts of methyl methacrylate, 3 parts of 2-hydroxyethyl methacrylate, 0.1 part of 2,2'-azobis(2-amidinopropane) dihydrochloride (polymerization initiator), 1.5 parts of sodium dodecylbenzene sulfonate (emulsifying agent) and 100 parts of water, and emulsion polymerization was carried out at 80°C for 5 hours. Following the completion of polymerization, 15% ammonia water was added to the reaction mixture so as to adjust the pH to 7.0, thereby giving an acrylic copolymer emulsion having a nonvolatiles content of 50%.
Hydrochloric acid was added to this emulsion to effect salting out, and the resulting coagulate was rinsed with water and dried, thereby giving an acrylic copolymer. This acrylic copolymer was dissolved in toluene to form a solution, and 5 parts of an isocyanate crosslinking agent (available from Nippon Polyurethane Industry Co., Ltd. under the trade name "Coronate L") and 0.05 part of dioctyltin dilaurate (available from Tokyo Fine Chemical Co., Ltd. under the trade name "Embilizer OL-1") were added thereto per 100 parts of the polymer. In addition, toluene was used to achieve a nonvolatiles content at which coating is easy to carry out, thereby giving the PSA composition of this example.
80 parts of PP (40 parts of crystalline homopolypropylene (HPP) having a resin density of 0.905/40 parts of random polypropylene (RPP) having a resin density of 0.900), 10 parts of PE (available from Tosoh Corporation under the trade name "Petrocene 205") and 10 parts of EPR (available from Mitsui Chemicals, Inc. under the trade name "Tafmer P0180") were extruded from a T-die so as to form a film (PP/PE/EPR film) having a thickness of 35 µm composed of a PP/PE/EPR blend, and corona discharge treatment was applied to one side thereof, thereby giving a substrate. Two such substrates were prepared. The above PSA composition was coated onto the corona discharge-treated side of the first substrate and dried at 80°C for 1 minute to form a PSA layer having a thickness of about 15 µm. The untreated side of the second substrate was bonded to this PSA layer and held for 2 days at 50°C, following which the second substrate was removed. A release liner was bonded to the exposed PSA layer, thereby giving a protective sheet according to this example.
The release liner used was composed of 115 µm thick high-quality paper laminated on each side with a 20 µm thick PE layer, and having a silicone release agent applied to one side thereof (the release side).

### Example 2

One side of a 30 µm thick non-oriented polypropylene (CPP) film (CPP film available from SunTox Co., Ltd. under the product number "MK 72") was subjected to corona discharge treatment, thereby giving a substrate. Aside from using this substrate, a protective sheet according to this example was obtained in the same way as in Example 1.

### Example 3

One side of a 30 µm thick CPP film was subjected to corona discharge treatment, thereby giving a substrate. The sum D_{SubS80} of the MD flexural rigidity and the TD flexural rigidity of this CPP film was 0.97x10⁻⁶ Pa·m³. Aside from using this substrate, a protective sheet according to this example was obtained in the same way as in Example 1.

### Example 4

Aside from not adding dioctyltin dilaurate (available from Tokyo Fine Chemical Co., Ltd. under the trade name "Embilizer OL-1") to the toluene solution of acrylic polymer, a PSA composition according to the present example was obtained in the same way as in Example 1. Using this PSA composition and the substrate of Example 1, a protective sheet according to the present example was obtained in the same way as in Example 1.

### Example 5

Crystalline homopropylene (HPP) having a resin density of 0.905 and a compound resin of random polypropylene (RPP) having a resin density of 0.900 with the above HPP (weight ratio, RPP : HPP =1:1) were extruded from a T-die so as to form a three-layer structure composed of a layer of the above compound resin between two layers of HPP (wherein the thickness ratio of the layers was HPP : compound resin : HPP = 1 : 3 : 1) and having a thickness of 40 µm. Corona discharge treatment was applied to one side thereof, giving a substrate. This PP film with a three-layer structure had a modulus of elasticity in the machine direction at room temperature of 477.2 MPa, and a modulus of elasticity in the transverse direction at the same temperature of 472.2 MPa. The total flexural rigidity D_{SubS80} of this substrate was 1.3 × 10⁻⁶ Pa·m³. Aside from using this substrate, a protective sheet according to this example was obtained in the same way as in Example 1.

### Example 6

Aside from using the substrate of Example 5, a protective sheet according to this example was obtained in the same way as in Example 1.

The following tests were carried out on the pressure-sensitive adhesives and the protective sheets according to each example. Those results are shown in Table 1, together with the compositions in the respective examples.

### Storage Modulus

The PSA compositions from the respective examples were coated onto the release side of a release liner and dried at 80°C for 3 minutes in such a way as not to allow foaming, thereby giving a PSA layer. This was layered on to a thickness of 2 mm so as to form a sample for measurement. This sample was punched out in a shape that matched a 7.9 mm diameter parallel plate, the PSA layer exposed by removing the release liner (substrate-less PSA sheet) was mounted on a viscoelastic analyzer (an ARES rheometer available from TA Instruments) and, while applying strain in the shear mode at a frequency of 1 Hz, the storage modulus G' at 100°C was measured in accordance with JIS K7244-1 by raising the temperature from 15°C to 150°C at a ramp-up rate of 5°C/min.

### 25°C Tensile Modulus

Test pieces were prepared by cutting each of the protective sheets into 10 mm wide strips, with the machine direction serving as the lengthwise direction. The test pieces were stretched under the following conditions in accordance with JIS K7161, thereby giving a stress-strain curve.
Measurement temperature: 25°C
Test rate: 300 mm/min
Chuck interval: 50 mm
The MD tensile modulus E_{M25} was determined by the linear regression of the curve between two specified points: the strains ε₁ = 1 and ε₂ = 2.The above measurements were carried out using three test pieces cut from different places, and the average of these measurements was treated as the tensile modulus E_{M25} (MPa) in the lengthwise direction (MD) at 25°C.
Test pieces were prepared by cutting each of the protective sheets into 10 mm wide strips, with the transverse direction serving as lengthwise direction. Using these test pieces, the tensile modulus E_{T25} (MPa) in the transverse direction at 25°C was determined in the same way as above.
The sum E_{S25} (MPa) was calculated from these measured values E_{M25} and E_{T25}.
Moreover, E_{M25} and E_{T25} were determined by calculating these values with respect to cross-sectional area of the substrate, based on the thickness value obtained by subtracting the thickness of the PSA layer from the measured thickness of each protective sheet.

### 80°C Tensile Modulus

Aside from setting the measurement temperature to 80°C, the MD tensile modulus E_{M80} (MPa) and the TD tensile modulus E_{T80} (MPa) (i.e., the values with respect to the cross-sectional area of the substrate) at 80°C were determined for each of the protective sheets in the same way as the 25°C tensile moduli.

### Flexural Rigidity

Using the formula D = Eh³/12(1-V²), the flexural rigidity values D_{M80} and D_{T80} were each calculated from the E_{M80} and E_{T80} measured above and the thickness h of each substrate, and the sum thereof D_{S80} (Pa.m³) was determined. A value of 0.35 was used as Poisson's ratio V in the above formula.

### Tension at 10% Stretch

Using test pieces cut out from the respective protective sheets as 10 mm wide strips, with the machine direction serving as the lengthwise direction, the tension of the test piece when stretched 10% in the machine direction was measured under the following conditions in accordance with JIS K7127.
Measurement temperature: 25°C
Test rate: 300 mm/min
Chuck interval: 50 mm
The above measurements were carried out using three test pieces cut from different places, and the average of these measurements was treated as the tension T_{M25} (N/10 mm) at 10% stretch in the machine direction.
Using test pieces cut out from the respective protective sheets as 10 mm wide strips, with the transverse direction serving as the lengthwise direction, the tension of the test piece when stretched 10% in the transverse direction was measured in the same way as described above, and the tension T_{T25} (N/10 mm) at 10% stretch in the transverse direction was determined.
The sum T_{S25} (N/10 mm) was determined from these measured values T_{M25} and T_{T25}.

### Tear Strength

Using test pieces cut out from the respective protective sheets as 40 mm x 150 mm strips, with the machine direction serving as the lengthwise direction, in accordance with JIS K6772, a cut was made, starting at the center of one of the short edges of the test piece and extending for a length of 75 mm parallel to the long edges. The edge of the test piece in which the above cut had been made was set in a tensile testing machine in such a way that the two sides of the cut faced in opposite directions, and pulling was carried out at a measurement temperature of 25°C and a rate of 300 mm/min until the test piece tore in the direction of the cut, at which time the maximum load was determined. The above measurements were carried out using three test pieces cut out from different places, and the average value for these was treated as the breaking strength S_{M25} (N) in the machine direction.
Using test pieces cut out from the respective protective sheets as 40 mm x 150 mm strips, with the transverse direction serving as the lengthwise direction, S_{T}-₂₅ (N) was measured in the same way as described above.
The sum S_{S25} (N) was determined from these measured values S_{M25} and S_{T25}.

### Breaking Strength

Using test pieces cut out from the respective protective sheets as 10 mm wide strips, with the machine direction serving as the lengthwise direction, in accordance with JIS K7161, the test pieces were pulled in the lengthwise direction under the same measurement conditions as described above for measuring tension at 10% stretch, and the load when the test piece broke (load at break) was measured. The above measurements were carried out using three test pieces cut out from different places (n=3), and the average value for these was treated as the breaking strength in the machine direction H_{M25} (N/10 mm).
Using test pieces cut out from the respective protective sheets as 10 mm wide strips, with the transverse direction serving as the lengthwise direction, the breaking strength in the transverse direction H_{T25} (N/10 mm) was measured in the same way as described above.
The sum H_{S25} (N/10 mm) was determined from these measured values H_{M25} and H_{T25}.

### Adhesive Strength When Heat and Pressure Bonded (PS_{HP-})

The adhesive strength PS_{HP} (N/10 mm) when heat and pressure bonded was measured as described above for each protective sheet.
In each case, an adherend having a protective sheet attached thereto was placed between PET films (with the release-treated face on the inside), and both sides thereof were in turn sandwiched between rubber sheets so as to keep the protective sheet from sticking to the rubber sheets during hot pressing. The PET films used were two pieces of PET film available from Mitsubishi Polyester Film under the trade name "Diafoil MRF38," each of which had been release-treated silicone on one side and cut to a size of 40 mm x 100 mm. The rubber sheets used were two pieces of 1.0 mm thick natural rubber (NBR) cut to the same size as the PET films. Based on the measurement results obtained in each example, the easy releasability was rated as follows.
Good: PS_{HP} was in a range of 0.1 N/10 mm to 1 N/10 mm.
NG: PS_{HP} was less than 0.1 N/10 mm or more than 1 N/10 mm.

### Durability During Peeling Evaluation (Presence/Absence of Tearing and Breaking)

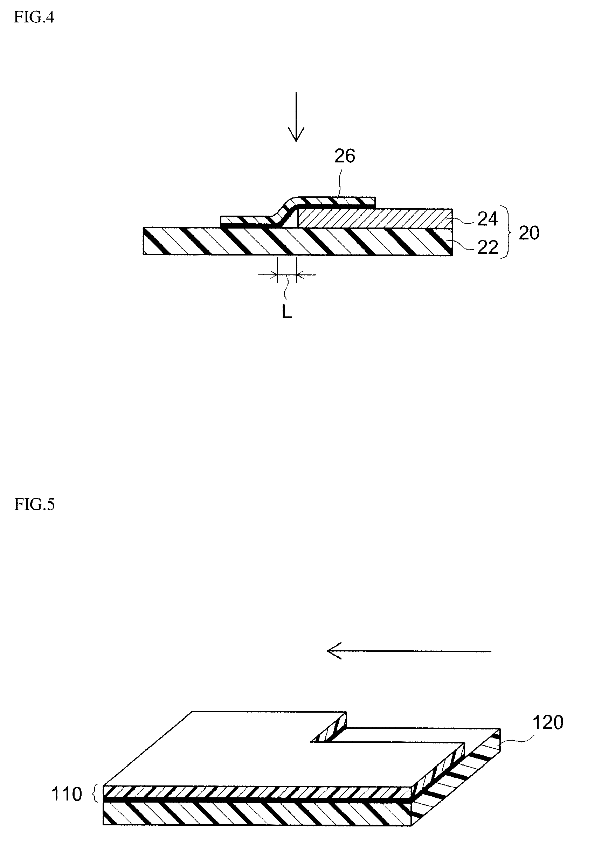

Referring to FIG. 5, test pieces 110 were prepared by cutting the respective protective sheets into 15 mm x 40 mm strips with the machine direction serving as the lengthwise direction, then cutting a portion having a width of 5 mm and a length of 20 mm from one corner of the strip. This test piece was attached to the PSA layer side of an evaluation adherend 120 (15 mm x 40 mm) similar to that used in the above measurements of PS_{HP}, and heat and pressure bonded under the same conditions and procedure as in PS_{HP} measurement, following which it was held at 50°C for 24 hours. Next, starting at the edge on the 10 mm wide side thereof (right side in FIG. 5), the test piece 110 was peeled from the adherend 120 in the lengthwise direction (direction of the arrow in FIG. 5) to a point 15 mm in from the edge so as to form a tab that can be gripped. In accordance with JIS Z0237, this tab portion was pulled in the lengthwise direction (direction of arrow in FIG. 5), at a temperature of 25°C, a pull rate of 300 mm/min and a peel angle of 180°, thereby completely peeling the test piece 110 from the adherend 120. The test piece 110 after peeling was visually checked for the presence or absence of tearing and/or breakage. Cases in which neither tearing nor breakage were observed are indicated in Table 1 as "no"; cases in which at least tearing or breakage was observed are indicated as "yes."

### Adherence

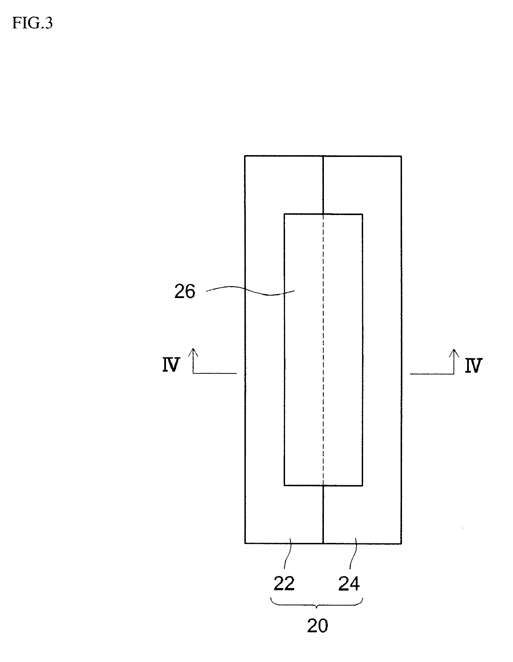

Assuming use in the manner of a protective sheet (protective sheet for masking in a plating operation) employed when plating a flexible printed circuit board (FPC), the adherence to steps (step conformability) between the FPC wiring (typically, copper wires) and the base film was evaluated.
As shown in FIGS. 3 and 4, a circuit board 20 was fabricated by bonding a 20 mm x 100 mm piece of copper foil 24 having a thickness of 35 µm to one side of a 40 mm x 100 mm PI film 22 (available from Toray Industries, Inc. under the trade name "Kapton 200 H") in such a way as to cover one-half of the surface area on one side of the PI film 22 along the lengthwise direction thereof. A test piece 26 of the respective protective sheets which had been cut to a size of 20 mm x 70 mm and from which the release liner had been removed was positioned on the board 20 so that substantially the center of the width coincided with the boundary between the PI film 22 and the copper foil 24, and was lightly bonded to the board with a hand roller. In the same way as when measuring the adhesive strength when heat and pressure bonded, the board 20 with the test piece 26 thereon was placed between release-treated PET films, and sandwiched in this manner between rubber sheets. The resulting assembly was arranged with the protective sheet side facing up, and pressed from above the rubber sheet at a temperature of 120°C and a pressure of 0.34 MPa for a pressing time of 5 seconds. After pressing, the vicinity of the boundary between the PI film 22 and the copper foil 24 of the board 20 to which the test piece 26 had been attached was examined from directly above (in the direction of the arrow in FIG. 4; that is, in a direction perpendicular to the surface of the board) to determine whether or not there was a gap L (an area where the PSA face of the test piece 26 lifts from the surface of the board 20) at the step between the copper foil 24 and the PI film 22 (see FIG. 4). Confirmation of the gap was carried out using a digital microscope manufactured by Keyence Corporation (magnification, 100X) at places 10 mm, 35 mm and 60 mm from one end of the test piece 26 in the lengthwise direction. Based on these results, the adherence of each protective sheet was rated as follows.
Good: The presence of a gap large enough to allow the infiltration of plating solution was not observed.
NG: Such a gap was observed to be present.

**Table 1**

| Example | | 1 | 2 | 3 | 4 | 5 | 6 |
|---|---|---|---|---|---|---|---|
| Substrate | Material | PP blend | PP | PP | PP blend | PP (3 layers) | PP (3 layers) |
| | Thickness (µm) | 35 | 30 | 30 | 35 | 40 | 40 |
| PSA layer | G' (MPa) | 0.343 | 0.343 | 0.343 | 0.227 | 0.227 | 0.343 |
| | Thickness (µm) | 15 | 15 | 15 | 15 | 15 | 15 |
| | Crosslinking accelerator | yes | yes | yes | no | no | yes |
| | D_{M80} (Pa·m³) | 0.54x10⁻ 6 | 0.51x10⁻ 6 | 0.51xlO⁻ 6 | 0.54x10⁻ 6 | 0.66x10⁻ 6 | 0.66x10⁻ 6 |
| | D_{T80} (Pa-m³) | 0.56x10⁻ 6 | 0.53x10⁻ 6 | 0.46x10⁻ 6 | 0.56x10⁻ 6 | 0.65x10⁻ 6 | 0.65x10⁻ 6 |
| | D_{S80} (Pa.m³) | 1.1x10⁻⁶ | 1.0x10⁻⁶ | 0.97x10⁻ 6 | 1.1X10⁻⁶ | 1.3x10⁻⁶ | 1.3x10⁻⁶ |
| | E_{M25} (MPa) | 642.7 | 730.4 | 701.4 | 642.7 | 499.4 | 499.4 |
| | E_{T25} (MPa) | 573.4 | 681.0 | 690.5 | 573.4 | 438.6 | 438.6 |
| | E_{S25} (MPa) | 1,216.1 | 1,411.4 | 1,391.9 | 1,216.1 | 938.0 | 938.0 |
| Protective sheet | T_{M25} (N/10 mm) | 8.3 | 7.4 | 7.8 | 7.8 | 8.6 | 8.6 |
| | T_{T25} (N/10 mm) | 7.4 | 7.3 | 7.4 | 6.9 | 6.9 | 6.9 |
| | T_{S25} (N/10 mm) | 15.7 | 14.7 | 15.1 | 14.8 | 15.5 | 15.5 |
| | S_{M25} (N) | 1.2 | 2.0 | 1.9 | 0.8 | 0.8 | 0.8 |
| | S_{T25} (N) | 8.2 | 5.4 | 7.1 | 4.2 | 3.5 | 3.5 |
| | S_{S25} (N) | 9.4 | 7.4 | 9.0 | 5.0 | 4.3 | 4.3 |
| | H_{M25}(N/10 mm) | 20.7 | 13.9 | 20.2 | 19.2 | 23.4 | 23.4 |
| | H_{T25} (N/10 mm) | 11.3 | 6.7 | 14.2 | 10.5 | 10.9 | 10.9 |
| | H_{S25} (N/10 mm) | 32.0 | 20.6 | 34.5 | 29.7 | 34.3 | 3.43 |
| | PS_{HP} (N/10 mm) | 0.55 | 0.68 | 0.64 | 1.35 | 1.41 | 0.43 |
| | Ease releasability | good | good | good | NG | NG | good |
| | Tearing and breaking | no | no | no | yes | yes | no |
| | Adherence | good | good | good | good | NG | NG |

| | | | | | | | |
|---|---|---|---|---|---|---|---|
| G': storage modulus; D: flexural rigidity E: tensile modulus; T: tension at 10% stretch S: tear strength; H: breaking strength: PS: peel strength | | | | | | | |

As shown in Table 1, the protective sheets in Examples 1 to 3, which were obtained using a PSA composition containing both a crosslinking agent and a crosslinking accelerator, which had a total flexural rigidity at 80°C (D_{S80}) in a range of from 0.1x10⁻⁶ Pa·m³ to 1.2x10^{- 6} Pa·m³, and in which the PSA layer had a storage modulus G' in a range of from [0.230x10⁶ Pa to 10x10⁶ Pa, all had excellent adherence to the adherend and exhibited easy releasability even after heat and pressure bonding. Moreover, the protective sheets did not tear or break apart during peeling. Hence, these protective sheets demonstrated an excellent balance between their performance as protective sheets and their ease of use.
On the other hand, the protective sheet in Example 4, which was obtained using a PSA composition containing no crosslinking accelerator and which had a G' smaller than 0.230x10⁶ Pa, exhibited a good adherence but did not peel well from the adherend. Moreover, tearing and breaking occurred during peeling. The protective sheet in Example 5, which was obtained using a PSA composition containing no crosslinking accelerator and which had a G' smaller than 0.230x10⁶ Pa and a D_{S80} greater than 1.2x10⁻⁶ Pa·m³, exhibited a poor adherence and a poor easy releasability, in addition to which tearing and breaking of the protective sheet occurred during peeling. The protective sheet in Example 6, although obtained using a PSA composition containing a crosslinking accelerator and having a G' in a range of from 0.230x10⁶ Pa to 10x10⁶ Pa, had a D_{S80} greater than 1.2x10⁻⁶ Pa·m³; it did not give rise to tearing and breakage during peeling, but had a poor adherence.

The embodiments thus disclosed in detail above are to be considered in all respects as illustrative and not limiting. The scope of the invention is indicated by the appended claims rather than by the foregoing description, and all changes which come within the meaning and range of equivalency of the claims are intended to be embraced therein.

## Claims

1. A protective sheet, comprising:
a substrate; and
a pressure-sensitive adhesive layer which is provided on one side of the substrate,
**characterized in that** the pressure-sensitive adhesive layer is formed of an acrylic pressure-sensitive adhesive composition which includes a crosslinking agent and a crosslinking accelerator, and
when defining the flexural rigidity D (units: Pa-m³) of the protective sheet in a predetermined direction as a value determined by the formula D = Eh³/12(1-V²), where E is a tensile modulus of the protective sheet in the predetermined direction, h is a thickness of the substrate and V is Poisson's ratio for the substrate, the following condition is satisfied:
(A) for the protective sheet, when D_{M80} represents a flexural rigidity at 80°C in a machine direction and D_{T80} represents a flexural rigidity at 80°C in a direction perpendicular to the machine direction, a sum D_{S80} of D_{M80} and D_{T80} is from 0.1x10⁻⁶ Pa.m³ to 1.2x10⁻⁶ Pa·m³ and the following property is further satisfied:
(B) the pressure-sensitive adhesive layer has a storage modulus G' at 100°C, as measured at a frequency of 1 Hz, in a range of from 0.230x10⁶ Pa to 10x10⁶ Pa.

2. The protective sheet according to claim 1, **characterized in that** the crosslinking accelerator is a tin-containing compound.

3. The protective sheet according to claim 1 or 2, **characterized in that** the crosslinking agent is an isocyanate crosslinking agent.

4. The protective sheet according to any one of claims 1 to 3, **characterized in that** the pressure-sensitive adhesive composition includes, as a base polymer, an acrylic polymer obtained by emulsion polymerization.

5. The protective sheet according to any one of claims 1 to 4, **characterized in that** the substrate is a polypropylene film.

6. The protective sheet according to any one of claims 1 to 5, which further satisfies the following condition:
(C) when the protective sheet is press bonded to an evaluation adherend at 120°C and a pressure of 0.34 MPa for a pressing time of 5 seconds, and then held at 50°C for 24 hours, the protective sheet has a peel strength PS_{HP}, as measured by peeling the protective sheet from the adherend at 25°C, a peel rate of 300 mm/min and a peel angle of 180°, of from 0.1 N/10 mm to 1 N/10 mm.

7. The protective sheet according to any one of claims 1 to 6, which further satisfies the following condition:
(D) for the protective sheet, when E_{M25} represents a tensile modulus at 25°C in a machine direction and E_{T25} represents a tensile modulus at 25°C in a direction perpendicular to the machine direction, a sum E_{S25} of E_{M25} and E_{T25} is from 50 MPa to 9000 MPa.

8. The protective sheet according to any one of claims 1 to 7, which further satisfies the following condition:
(E) for the protective sheet, when T_{M25} represents a tension when stretched 10% in a machine direction at 25°C and T_{T25} represents a tension when stretched 10% in a direction perpendicular to the machine direction at 25°C, a sum T_{S25} of T_{M25} and T_{T25} is from 8 N/10 mm to 60 N/10 mm.

9. The protective sheet according to any one of claims 1 to 8, which is a protective sheet for masking during plating and is attached to a non-plating area during metal plating so as to protect the non-plating area from a plating solution.

10. Use of the protective sheet according to any one of claims 1 to 9, as a protective sheet for masking during plating, which is attached to a non-plating area during metal plating so as to protect the non-plating area from a plating solution.
